Europäisches Patentamt

European Patent Office

Office européen des brevets

(19)

(11) **EP 1 096 264 A1**

(12) **DEMANDE DE BREVET EUROPEEN**

(43) Date de publication:
02.05.2001 Bulletin 2001/18

(51) Int. Cl.⁷: **G01R 31/36**

(21) Numéro de dépôt: **00203613.5**

(22) Date de dépôt: **18.10.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **26.10.1999 FR 9913361**

(71) Demandeur:
**Koninklijke Philips Electronics N.V.
5621 BA Eindhoven (NL)**

(72) Inventeur: **Hing, Sothun
75008 Paris (FR)**

(74) Mandataire:
**den Braber, Gerard Paul
Société Civile "S.P.I.D.",
156, Boulevard Haussmann
75008 Paris (FR)**

(54) **Dispositif pour estimer l'etat de charge d'une batterie**

(57) L'invention concerne un dispositif (1) pour estimer l'état de charge d'une batterie rechargeable (BAT) au moyen d'un circuit de mesure (MES). Ce dispositif de mesure comporte au moins deux valeurs seuil initiales correspondant à des états de charge donnés de la batterie et qui, par comparaison avec la tension aux bornes de la batterie, permettent de donner une indication de l'état de charge de la batterie. L'invention consiste à effectuer une correction de ces valeurs seuil initiales en fonction du temps cumulé de fonctionnement de la batterie afin d'obtenir un ensemble de valeurs seuil corrigées. La tension aux bornes de la batterie est alors comparée à ces valeurs seuil corrigées.

Applications: téléphonie

FIG.1

## Description

L'invention concerne un dispositif comprenant au moins:

- une batterie rechargeable,
- un circuit de mesure pour fournir une grandeur représentant un état de charge de la batterie à partir d'au moins deux valeurs seuil initiales telles qu'un ensemble de valeurs délimité par deux valeurs seuil initiales consécutives est respectivement associé à une grandeur représentant un état de charge de la batterie.

L'invention concerne aussi un radiotéléphone muni d'un tel dispositif.

L'invention concerne une méthode pour estimer un état de charge d'une batterie. La présente invention est particulièrement intéressante dans des applications liées à la téléphonie mobile.

Une batterie rechargeable fonctionne suivant des cycles d'utilisation successifs, un cycle correspondant à une charge complète suivie d'une décharge complète de la batterie. Une batterie, lorsqu'elle vieillit, se détériore et, après plusieurs cycles d'utilisation, présente des caractéristiques de fonctionnement différentes d'une batterie neuve. Une batterie comporte des électrodes ou plaques qui s'oxydent au cours du fonctionnement et modifient les caractéristiques de fonctionnement de la batterie. Un dispositif d'estimation de la charge d'une batterie est connu du document US 5,404,106. Ce document propose un dispositif permettant d'estimer une capacité de charge restante indépendamment de l'état de dégradation de plaques positives et négatives de la batterie. Le dispositif dispose en mémoire de tables indiquant la capacité de charge restante en fonction d'une mesure de la résistance interne de la batterie et d'une mesure de courant de décharge. Un problème d'un dispositif décrit dans ce document est d'indiquer une capacité de charge restante relative à la capacité totale initiale de charge de la batterie avant détérioration des plaques. Ainsi, par exemple, après plusieurs cycles de fonctionnement de la batterie, un tel dispositif n'indique pas nécessairement une capacité de charge maximale lorsque la batterie est chargée.

Un but de l'invention est de fournir un dispositif qui permet une estimation précise et réelle de l'état de charge d'une batterie en fonction des caractéristiques de fonctionnement actuelles de la batterie.

Pour cela, le circuit de mesure du dispositif tel que décrit dans le préambule fournit ladite grandeur à partir de valeurs seuil corrigées obtenues par correction des valeurs seuil initiales en fonction d'une approximation du temps cumulé de fonctionnement de la batterie.

Un dispositif selon l'invention permet d'effectuer une mesure de l'état de charge d'une batterie en tenant compte des modifications des caractéristiques de la batterie dues à une succession de plusieurs cycles d'utilisation de la batterie. Contrairement au dispositif décrit dans le document de l'art antérieur, l'état de charge est mesuré par rapport à la capacité de charge totale de la batterie à l'instant de la mesure, cette capacité totale de charge étant modifiée lors du fonctionnement de la batterie. Un avantage d'un dispositif selon l'invention est d'informer correctement un utilisateur de la capacité de charge de la batterie à un instant donné par rapport à la capacité de charge totale au même instant quel que soit l'état de vieillissement de la batterie.

Dans un mode de réalisation préféré de l'invention, l'approximation du temps cumulé de fonctionnement de la batterie est fonction d'une mesure de la résistance interne de la batterie.

Dans un mode de réalisation de l'invention, le dispositif de mesure comporte:

- des moyens pour mesurer la tension aux bornes de la batterie,
- des moyens pour comparer la tension aux bornes de la batterie avec les valeurs seuil corrigées et fournir ladite grandeur représentant l'état de charge de la batterie en fonction du résultat de cette comparaison.

De façon générale la capacité de charge restante dans une batterie, à un instant donné, peut être estimée à partir d'une mesure de la tension aux bornes de la batterie. Un ensemble de valeur seuil de cette tension correspondant à différents états de charge de la batterie est disponible en mémoire. La tension mesurée aux bornes de la batterie est comparée à ces valeurs seuil et une grandeur représentant l'état de charge corrigé de la batterie est déduite de cette comparaison.

L'invention sera mieux comprise à la lumière de la description suivante de quelques modes de réalisation, faite à titre d'exemple et en regard des dessins annexés, dans lesquels:

- la figure 1 est un schéma bloc d'un dispositif selon l'invention,
- la figure 2 montre des courbes de décharge d'une batterie pour différents temps cumulés de fonctionnement de la batterie,
- la figure 3 montre différentes étapes d'une méthode selon l'invention,

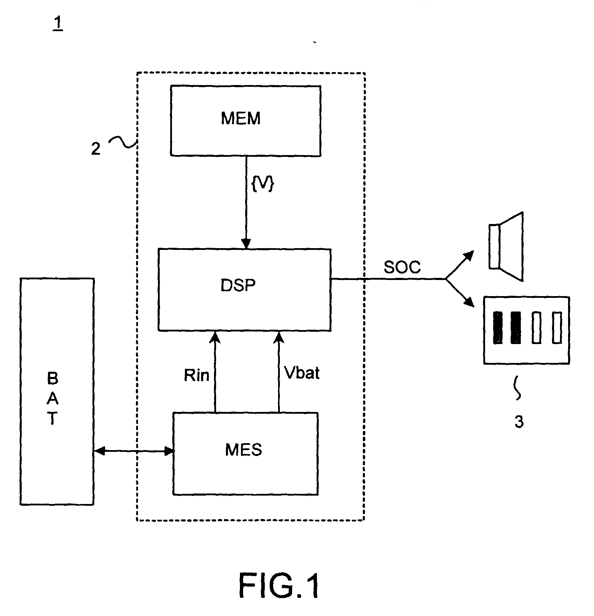

Un mode de réalisation d'un dispositif 1 selon l'invention est représenté en figure 1. Un dispositif 1 suivant l'invention, comporte une batterie rechargeable BAT dont on veut estimer une grandeur SOC représentant son état de charge à un instant donné. Pour cela le dispositif 1 comporte un circuit de mesure 2 pour fournir la grandeur SOC. Le circuit de mesure 2 comporte des moyens de mesure MES pour mesurer la tension Vbat aux bornes de la batterie BAT et la résistance interne Rin de la batterie. Comme expliqué précédemment, la batterie BAT se détériore au cours de son fonctionnement en raison de pertes de matières actives des électrodes de la batterie BAT. Ceci a pour conséquence une augmentation de la résistance interne Rin de la batterie BAT. L'évolution de cette résistance interne Rin avec le temps est fonction d'une approximation du temps cumulé de fonctionnement T de la batterie BAT. Dans la suite on emploiera l'expression temps cumulé de fonctionnement pour désigner une approximation de ce temps cumulé de fonctionnement. Ce temps cumulé de fonctionnement T correspond au temps total de fonctionnement de la batterie BAT depuis sa première utilisation. Dans un mode de réalisation de l'invention, le temps cumulé de fonctionnement T de la batterie BAT peut être évalué selon l'équation (1):

$$T = \frac{(Ln(Rin)-Ln(A))}{B} \qquad (1)$$

T étant le temps cumulé de fonctionnement de la batterie évalué en nombre de cycles d'utilisation de la batterie BAT; A et B étant des constantes.

Le temps cumulé de fonctionnement T de la batterie est estimé dans un circuit de calcul DSP. Le circuit de calcul DSP peut en outre accéder à une mémoire MEM dans laquelle sont mémorisées un ensemble de valeurs seuils {V} de la tension Vbat aux bornes de la batterie permettant une détermination de la grandeur SOC, l'ensemble {V} comportant au moins deux valeurs seuil. Les valeurs de la tension Vbat aux bornes de la batterie comprises entre deux valeurs seuil consécutives sont associées à une grandeur SOC représentant un état de charge donné de la batterie BAT. Cet ensemble de valeurs seuil {V} est associé à un temps cumulé de fonctionnement T de la batterie BAT donné. Dans ce mode de réalisation on considère que les valeurs seuil {V} mémorisées dans la mémoire MEM sont issues d'une courbe typique de décharge à courant constant de la batterie BAT à l'état neuf c'est-à-dire pour T nul. Dans ce mode de réalisation de l'invention, les valeurs seuil {V} sont corrigées dans le circuit de calcul DSP en fonction du temps cumulé de fonctionnement T de la batterie BAT comme décrit ultérieurement. La grandeur SOC peut ensuite être transmise à un dispositif d'indication 3 pour afficher de façon visuelle la grandeur SOC. Le dispositif d'indication 3 peut aussi être un témoin lumineux, un témoin sonore ou tout autre moyen d'indication.

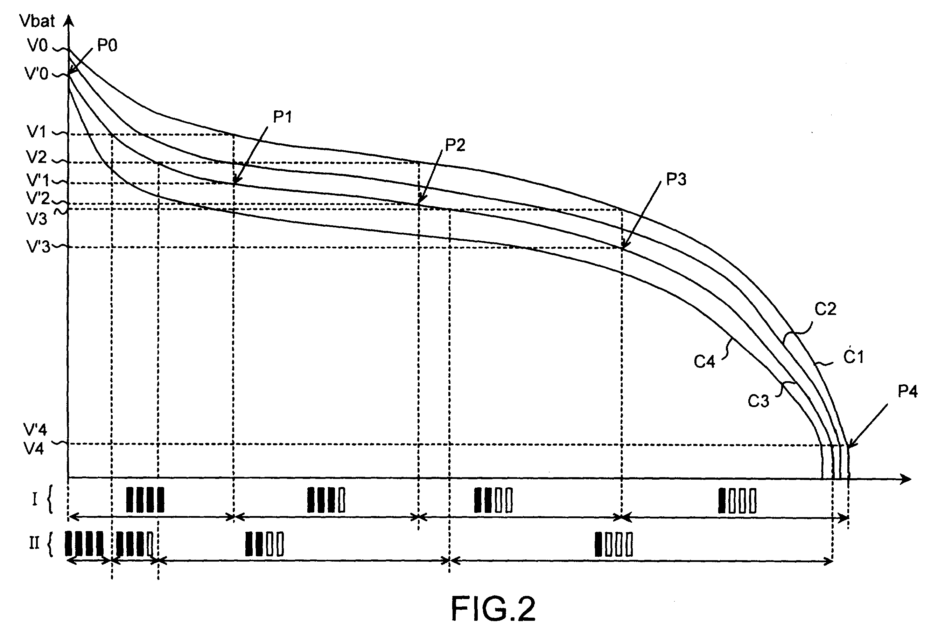

Le comportement de la batterie BAT lors de différentes décharges à courant constant est représenté par les caractéristiques de décharge C1, C2, C3 et C4 de la figure 2. Les courbes C1, C2, C3 et C4 indiquent chacune, pour des temps cumulés de fonctionnement T différents, lors de la décharge de la batterie BAT à courant constant, la grandeur SOC représentant l'état de charge de la batterie BAT en abscisse, en fonction de la tension Vbat aux bornes de la batterie BAT en ordonnée. Dans un mode de réalisation, la grandeur SOC peut par exemple être le rapport de la charge de la batterie à un instant donné par rapport à la capacité de charge totale possible de la batterie BAT au même instant. Ainsi, dans ce mode de réalisation de l'invention, la grandeur SOC est un nombre réel compris entre 0 et 1, 0 correspondant à une batterie BAT déchargée et 1 à une batterie BAT chargée au maximum de sa capacité. Le temps cumulé de fonctionnement T est, ici, par exemple le nombre total de cycles de charge et décharge successives de la batterie et est représentatif de l'état de vieillissement de la batterie. La courbe C1 représente la caractéristique de décharge de la batterie BAT pour un temps cumulé de fonctionnement T1 nul c'est-à-dire lorsque la batterie BAT est neuve. Les courbes C2, C3 et C4 représentent les caractéristiques de décharge de la batterie BAT pour des temps cumulés de fonctionnement non nuls T2, T3 et T4, respectivement, T2 étant inférieur à T3 et T3 étant inférieur à T4.

Afin d'évaluer la grandeur SOC, une mesure de la tension Vbat aux bornes de la batterie est effectuée et la tension Vbat mesurée est comparée à un nombre arbitraire de valeurs seuil initiales {V}. Dans ce mode de réalisation de l'invention, les valeurs seuil V0, V1, V2, V3, V4 forment l'ensemble {V} et sont définies telles que V0>V1>V2>V3>V4≥0. Ces valeurs seuil initiales V0, V1, V2, V3, V4 sont préalablement fixées en fonction de la courbe de décharge C1 de la batterie lorsque la batterie BAT est neuve et mémorisées dans une mémoire propre ou externe à la batterie. La valeur seuil V0 est préférablement choisie comme la valeur de la tension Vbat aux bornes de la batterie BAT à l'état neuf lorsque celle-ci est chargée au maximum de sa capadté. L'ensemble des mesures de la tension Vbat appartenant à un intervalle délimité par deux valeurs seuil successives correspondent à une valeur de ladite grandeur SOC représentant un état de charge donné de la batterie BAT. Dans un mode de réalisation de l'invention, les valeurs seuil initiales V0, V1, V2, V3, V4 sont fixées telles que chaque intervalle délimité par deux valeurs seuil successives représente 1/4 de la charge totale de la batterie lorsque celle-ci est neuve. Dans un mode de réalisation la valeur maximale V0 de la tension de la batterie BAT peut ne pas être considérée comme étant une valeur seuil. L'ensemble des mesures de la tension Vbat supérieures à V1 est alors équivalent à l'ensemble des mesures de la tension Vbat appartenant à l'intervalle ]V1;V0].

Dans un mode de réalisation de l'invention, cette grandeur SOC peut être une valeur numérique. Cette grandeur SOC peut aussi apparaître sous la forme d'un caractère ou d'un symbole représentant un état de charge de la batterie BAT. Dans un mode de réalisation de l'invention, la grandeur SOC peut être affichée sous la forme de quatre symboles comportant chacun quatre barres parallèles vides ou pleines selon l'état de charge de la batterie, comme représenté en figure 1 par une situation L Lorsque la tension mesurée Vbat aux bornes de la batterie BAT appartient à ]V1, V0], une grandeur SOC représentée par 4 barres pleines peut être affichée. Lorsque la tension Vbat appartient à l'intervalle ]V2, V1] l'état de charge de la batterie BAT peut être représenté par 3 barres pleines et 1 barre vide. Lorsque la tension Vbat appartient à l'intervalle ]V3, V2], l'état de charge de la batterie BAT peut être représenté par 2 barres pleines et 2 barres vides. Lorsque la tension Vbat appartient à l'intervalle ]V4, V3], l'état de charge de la batterie BAT peut être représenté par 1 barre pleine et 3 barres vides. Lorsque la tension Vbat est inférieure à V4, la batterie BAT est considérée comme étant déchargée.

On étudie, dans ce paragraphe, le fonctionnement de la batterie BAT après le temps cumulé de fonctionnement T3. Lorsque les valeurs seuil V0, V1, V2, V3 et V4 telles que décrites dans un paragraphe précédent sont utilisées pour estimer l'état de charge de la batterie BAT, une situation II est obtenue. En effet, lorsque la tension Vbat aux bornes de la batterie BAT est comprise entre V1 et V0, l'état de charge correspondant de la batterie BAT peut être représenté par 4 barres pleines. De même, lorsque la tension Vbat appartient aux intervalles ]V2, V1], ]V3, V2], ]V4, V3] l'état de charge de la batterie peut être respectivement représenté par 3 barres pleines et 1 barre vide, 2 barres pleines et 2 barres vides, une barre pleine et 3 barres vides. Ainsi en se basant sur les valeurs seuil initiales V0, V1, V2, V3, V4 déterminées lorsque la batterie BAT est neuve, la grandeur SOC obtenue, après un temps cumulé de fonctionnement T3, est une représentation erronée de l'état de charge de la batterie.

Dans un mode de réalisation de l'invention, les valeurs seuil V0, V1, V2, V3, V4 sont corrigées en fonction du temps cumulé d'utilisation T de la batterie et des valeurs seuil corrigées V'0, V'1, V'2, V'3 et V'4 sont obtenues pour un temps cumulé d'utilisation T3. Dans ce mode de réalisation de l'invention, les valeurs seuil corrigées V'0, V'1, V'2, V'3 et V'4 représentées en figure 1 correspondent aux ordonnées des points P0, P1, P2, P3, P4 de la courbe C3 ayant des abscisses respectives représentant chacune 4/4, 3/4, 2/4, 1/4, 0/4 de la capacité totale de charge de la batterie BAT. Ainsi une estimation de l'état de charge de la batterie BAT au bout d'un temps cumulé d'utilisation T3 basée sur les valeurs seuil corrigées V'0, V'1, V'2, V'3, V'4 aboutit à la situation I.

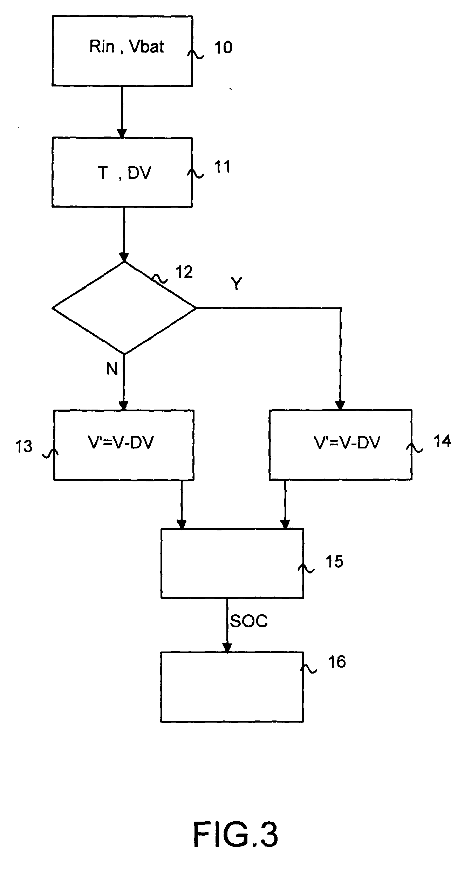

La figure 3 présente différentes étapes d'une méthode selon l'invention qui peut être implémentée dans le dispositif 1 de la figure 2 pour évaluer la grandeur SOC représentant l'état de charge de la batterie BAT. Une première étape 10 consiste à mesurer la tension Vbat aux bornes de la batterie BAT et la résistance interne Rin de la batterie. La tension Vbat est mesurée par les moyens de mesure MES. Les moyens de mesure MES effectuent en outre une mesure de chute de tension ΔV aux bornes de la batterie BAT due à différents régimes de décharge correspondant chacun à une valeur donnée du courant de décharge. La valeur de la résistance interne est déduite de ces mesures comme le rapport de la chute de tension ΔV et de la différence ΔI des courants de décharge correspondants. Dans un mode de réalisation où le dispositif 1 est un radiotéléphone la mesure de la résistance Rin peut être effectuée lors de deux régimes de décharge différents tels un régime de repos du radiotéléphone et un régime de recherche du réseau par exemple. Une seconde étape 11 consiste à estimer dans le circuit de calcul DSP le temps cumulé de fonctionnement T de la batterie BAT à partir de la mesure de la résistance interne Rin en appliquant l'équation (1). La seconde étape consiste aussi à calculer un ensemble de déviations correctrices {DV} destinées à être retranchées à chacune des valeurs seuil initiales {V} afin d'obtenir un ensemble de valeurs seuil corrigées {V'}. Ces déviations correctrices sont, dans un mode de réalisation possible de l'invention, toute égales et estimées à partir du temps cumulé de fonctionnement T de la batterie de la façon suivante:

$$DV = I \times T + J \times T^2 \qquad (2)$$

avec I et J constante.

Dans un mode de réalisation préféré de l'invention, la batterie peut être utilisée suivant plusieurs mode: un mode de repos ou un mode actif, par exemple. Une telle batterie peut être utilisée dans des applications liées à la radiotéléphonie. Un radiotéléphone qui peut être représenté par le dispositif 1 selon l'invention peut comporter une batterie BAT qui est dans un mode de repos lorsque le radiotéléphone ne transmet pas de communication et en mode actif autrement. Chaque mode est alors caractérisé par une courbe de décharge différente et de ce fait un ensemble de valeurs seuil initiales {V}, telles que décrites dans un paragraphe précédent, est associé à chacun des modes. Une étape 12 consiste donc à déterminer le mode d'utilisation de la batterie BAT. Ensuite une étape 13 associée par exemple au mode dit de repos ou une étape 14, associée au mode dit actif, consiste à accéder l'ensemble des valeur seuil initiales {V} correspondant au mode d'utilisation de la batterie. Les valeurs seuil corrigées {V'} sont obtenues à partir de ces valeurs seuil initiales {V} en retranchant la déviation correctrice DV, calculée précédemment, aux valeurs seuil initiales {V}.

Une étape 15 consiste à comparer la tension Vbat mesurée avec les valeurs seuil corrigées {V'} et à déduire de cette comparaison la grandeur SOC représentant l'état de charge de la batterie BAT. Enfin une possible étape 16 d'une méthode selon l'invention consiste à signaler à un utilisateur de façon sonore, tactile ou visuelle la grandeur SOC représentant l'état de charge de la batterie BAT.

Les figures proposées dans ce document ne doivent pas être considérées comme limitatives vis-à-vis de l'objet de l'invention. La figure 1 propose un mode particulier de réalisation de l'invention et il est possible d'envisager une batterie pour laquelle le circuit de mesure 2 est interne à la batterie.

Il convient de noter que dans ce texte le mot "comprenant" n'exclut pas la présence d'autres éléments ou étapes que ceux listés dans une revendication.

Par ailleurs, il convient aussi de noter que vis-à-vis de la méthode décrite, toute modification ou amélioration peut être proposée sans se détourner de l'objet de l'invention. Il est clair que la méthode proposée peut être implémentée de plusieurs manières, telle qu'au moyen de circuits électroniques ou alternativement au moyen d'un ensemble d'instructions mémorisées sur un support d'information et pouvant être exécutées sous le contrôle d'un processeur ou d'un ordinateur.

## Revendications

1. Dispositif comprenant au moins :

   - une batterie rechargeable,
   - un circuit de mesure pour fournir une grandeur représentant un état de charge de la batterie à partir d'au moins deux valeurs seuil initiales telles qu'un ensemble de valeurs délimité par deux valeurs seuil initiales consécutives est respectivement associé à une grandeur représentant un état de charge de la batterie, caractérisé en ce que le circuit de mesure fournit ladite grandeur à partir de valeurs seuil corrigées obtenues par correction des valeurs seuil initiales en fonction d'une approximation du temps cumulé de fonctionnement de la batterie.

2. Dispositif selon la revendication 1, caractérisé en ce que l'approximation du temps cumulé de fonctionnement de la batterie est fonction d'une mesure de la résistance interne de la batterie.

3. Dispositif selon la revendication 2, caractérisé en ce que l'approximation du temps cumulé de fonctionnement de la batterie est définie par $\frac{Ln(Rin)-Ln(A)}{B}$ où Rin est la mesure de la résistance interne et A et B sont des constantes.

4. Dispositif selon la revendication 1, caractérisé en ce que le circuit de mesure comporte :

   - des moyens pour mesurer la tension aux bornes de la batterie,
   - des moyens pour comparer la tension aux bornes de ta batterie avec les valeurs seuil corrigées et fournir ladite grandeur représentant l'état de charge de la batterie en fonction du résultat de cette comparaison.

5. Radiotéléphone comportant un dispositif selon la revendication 1 et un dispositif pour indiquer ladite grandeur représentant un état de charge de la batterie.

6. Méthode pour estimer un état de charge d'une batterie comprenant au moins deux valeurs seuil initiales telles qu'un ensemble de valeurs délimité par deux valeurs seuil initiales consécutives est respectivement associé à une grandeur représentant un état de charge de la batterie, caractérisée en ce qu'elle comprend au moins les étapes suivantes :

   - mesure de la tension aux bornes de la batterie,
   - mesure de la résistance interne de la batterie,
   - correction des valeurs seuil initiales en fonction de la valeur de la résistance interne de la batterie pour obtenir des valeurs seuil corrigées,
   - comparaison de la tension de décharge avec les valeurs seuil corrigées pour obtenir l'état de charge de la batterie.

7. Support d'information comprenant un noyau de programme pour mémoriser une série d'instructions exécutables sous le contrôle d'un ordinateur ou d'un processeur qui permettent la réalisation d'une partie des étapes d'une méthode selon la revendication 6.

1

2

FIG.1

FIG.2

Rin , Vbat    10

T , DV    11

12    Y

N

13    V'=V-DV        V'=V-DV    14

15

SOC

16

# FIG.3

EP 1 096 264 A1

Office européen
des brevets

RAPPORT DE RECHERCHE EUROPEENNE

Numéro de la demande
EP 00 20 3613

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 5 936 383 A (NG PATRICK KWOK-YEUNG ET AL) 10 août 1999 (1999-08-10) * revendications 1,13 * | 1,2,4,6 | G01R31/36 |
| A | EP 0 714 033 A (AT & T CORP) 29 mai 1996 (1996-05-29) * revendication 1 * | 1,6 | |
| A | PATENT ABSTRACTS OF JAPAN vol. 1998, no. 03, 27 février 1998 (1998-02-27) & JP 09 297166 A (SONY CORP), 18 novembre 1997 (1997-11-18) * abrégé * | 5 | |

DOMAINES TECHNIQUES RECHERCHES (Int.Cl.7)

G01R

Le présent rapport a été établi pour toutes les revendications

| Lieu de la recherche | Date d'achèvement de la recherche | Examinateur |
|---|---|---|
| LA HAYE | 14 novembre 2000 | Six, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

9

EP 1 096 264 A1

ANNEXE AU RAPPORT DE RECHERCHE EUROPEENNE
RELATIF A LA DEMANDE DE BREVET EUROPEEN NO.

EP 00 20 3613

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-11-2000

| Document brevet cité au rapport de recherche | | Date de publication | Membre(s) de la famille de brevet(s) | | Date de publication |
|---|---|---|---|---|---|
| US 5936383 | A | 10-08-1999 | AUCUN | | |
| EP 0714033 | A | 29-05-1996 | US | 5631540 A | 20-05-1997 |
| | | | CN | 1132355 A | 02-10-1996 |
| | | | JP | 8233918 A | 13-09-1996 |
| | | | SG | 34288 A | 06-12-1996 |
| JP 09297166 | A | 18-11-1997 | CN | 1166711 A | 03-12-1997 |
| | | | EP | 0794438 A | 10-09-1997 |